# EUROPEAN PATENT APPLICATION

(11) **EP 2 615 146 A2**
(43) Date of publication of application: **17.07.2013**
(21) Application number: 13150469.8
(22) Date of filing: 08.01.2013
(51) Int. Cl.: C09J 7/02, C08K 3/08, C08K 3/22

(54) **Conductive adhesive sheet and solar cell module**

(30) Priority: 10.01.2012 JP 2012002070
(71) Applicant: NITTO DENKO CORPORATION, Ibaraki-shi, Osaka 567-8680 (JP)
(72) Inventor: Furukawa, Yoshihiro, Osaka 567-8680 (JP); Ebe, Hirofumi, Osaka 567-8680 (JP)
(74) Representative: HOFFMANN EITLE

(57) **Abstract**

A conductive adhesive sheet includes a conductive adhesive layer, and a light reflective layer formed on one surface in the thickness direction of the conductive adhesive layer.

## Description

### BACKGROUND OF THE INVENTION

### Field of the Invention

The present invention relates to a conductive adhesive sheet and a solar cell module, particularly to a conductive adhesive sheet, and a solar cell module including a plurality of back contact solar cells having back electrodes connected with the conductive adhesive sheet.

### Description of Related Art

Conventionally, a solar cell module including the following has been known: a plurality of solar cells disposed in spaced-apart relation to each other; electrodes (positive electrode and negative electrode) provided on both of the front surface (light-receiving surface) and the rear surface of each of the solar cells; and a conductive joining member that electrically connects the electrodes so as to join (fix) the adjacent solar cells. In this solar cell, sunlight is received by the light-receiving surface of the solar cell, and electric energy generated in the solar cell is collected by the conductive joining member from both electrodes of the front surface and the rear surface.

Meanwhile, for example, Japanese Unexamined Patent Publication No. 2011-159726 has recently proposed, for the purpose of obtaining a larger electric energy, a solar cell module including a plurality of solar cells (back contact type) disposed in line in spaced-apart relation to each other; a back electrode provided on each of their rear surfaces; and a wiring board that electrically connects the back electrodes.

With the solar cell module of Japanese Unexamined Patent Publication No. 2011-159726, sunlight can be received with the entire surface of the light-receiving surface, and therefore a larger electric energy can be obtained.

### SUMMARY OF THE INVENTION

However, the back contact solar cell of Japanese Unexamined Patent Publication No. 2011-159726 cannot achieve effective use of sunlight that passes through the gaps between the plurality of solar cells. Therefore, a larger electric energy cannot be obtained, and disadvantageously, sufficient improvement in power generation efficiency cannot be achieved.

An object of the present invention is to provide a conductive adhesive sheet that reliably allows adhesion and electrical connection between the back electrodes of the plurality of solar cells, allows production of a larger electric energy, and sufficiently improves power generation efficiency; and a solar cell module in which the conductive adhesive sheet is used.

A conductive adhesive sheet includes a conductive adhesive layer, and a light reflective layer formed on one surface in the thickness direction of the conductive adhesive layer.

In the conductive adhesive sheet of the present invention, it is preferable that the conductive adhesive layer is formed from a conductive adhesive composition containing lead-free solder particles, a high melting point metal particles, and a resin.

In the conductive adhesive sheet of the present invention, it is preferable that the lead-free solder particles have a melting point of 200°C or less.

In the conductive adhesive sheet of the present invention, it is preferable that the lead-free solder particles are a tin-bismuth alloy.

In the conductive adhesive sheet of the present invention, it is preferable that the amount of the lead-free solder particles relative to the conductive adhesive composition is 15 vol% or more and 90 vol% or less.

In the conductive adhesive sheet of the present invention, it is preferable that the resin contains a thermosetting resin.

In the conductive adhesive sheet of the present invention, it is preferable that the conductive adhesive composition further contains an activator.

In the conductive adhesive sheet of the present invention, it is preferable that the light reflective layer contains titanium oxide particles.

A solar cell module of the present invention includes a plurality of back contact solar cells disposed in spaced-apart relation to each other; and a conductive adhesive sheet that connects the back electrodes of the plurality of back contact solar cells so that a light reflective layer is exposed to a front side from gaps between the plurality of back contact solar cells.

In the solar cell module of the present invention, the conductive adhesive sheet of the present invention connects the back electrodes of the plurality of back contact solar cells disposed in spaced-apart relation to each other. Therefore, the plurality of back contact solar cells are bonded and fixed, and electrical conduction between the back electrodes can be achieved.

Meanwhile, in the light reflective layer exposed to the front side from the gaps between the back contact solar cells, the sunlight that passes between the back contact solar cells can be reflected, and therefore the reflected light can be received in the back contact solar cell. Thus, the sunlight that passes between the back contact solar cells can be effectively used.

The conductive adhesive layer and the light reflective layer can reinforce the surrounding of the solder joining portion between the conductive adhesive sheet and the back electrodes joined by the conductive adhesive sheet.

Thus, reliability of the solar cell module including the back contact solar cells whose back electrodes are connected by the conductive adhesive sheet can be improved.

### BRIEF DESCRIPTION OF THE DRAWINGS

FIG. 1 shows a cross-sectional view of a conductive adhesive sheet in an embodiment of the present invention.
FIG. 2 shows a solar cell module in an embodiment of the present invention,
   (a) showing a plan view, and
   (b) showing a bottom view thereof.
FIG. 3 shows a cross-sectional view taken along line A-A of the solar cell module of FIG. 2 (b).
FIG. 4 is a process drawing illustrating a method for producing a solar cell module shown in FIG. 3,
   (a) illustrating a step of preparing a conductive adhesive sheet,
   (b) illustrating a step of thermocompression bonding the conductive adhesive sheet to back electrodes (first thermocompression bonding step), and
   (c) illustrating a step of further thermocompression bonding the conductive adhesive sheet to the back electrodes (second thermocompression bonding step).

### DETAILED DESCRIPTION OF THE INVENTION

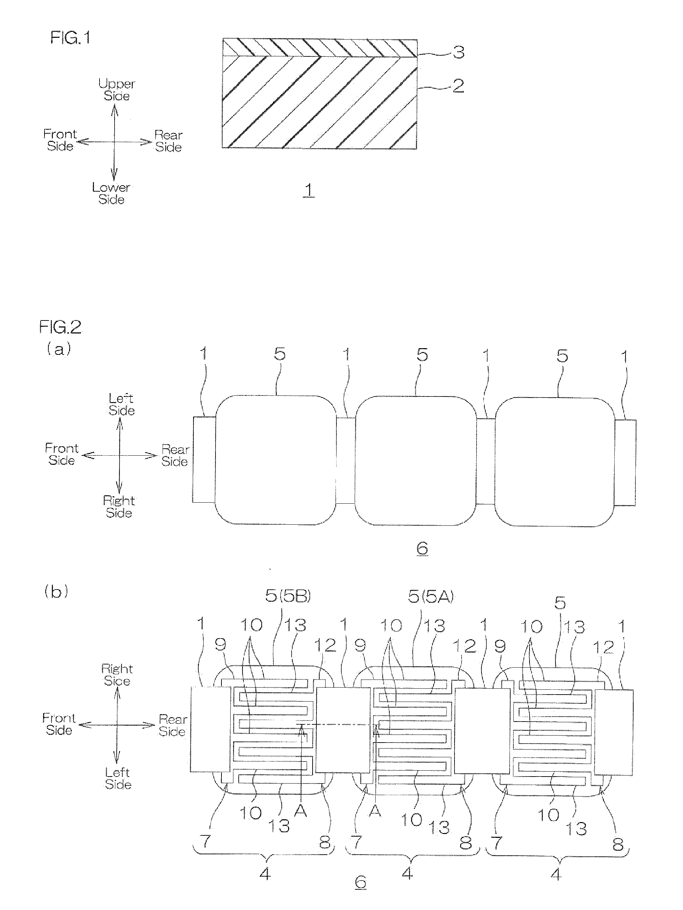

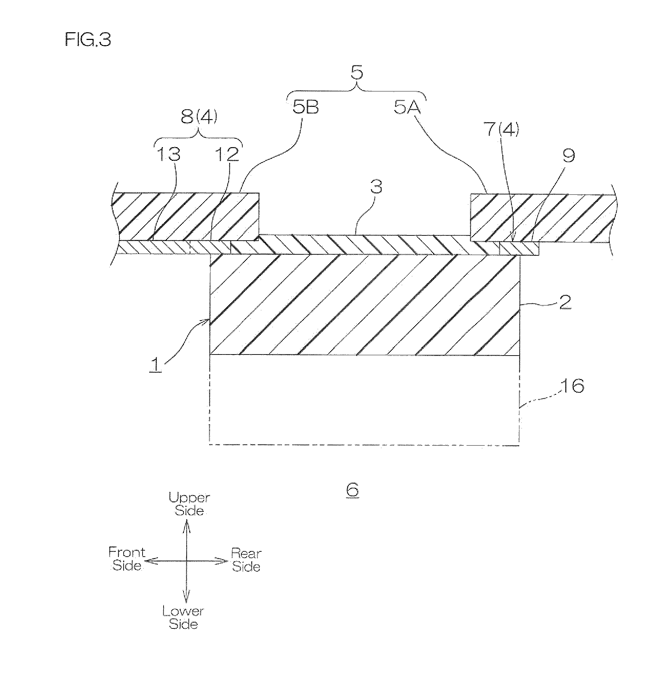

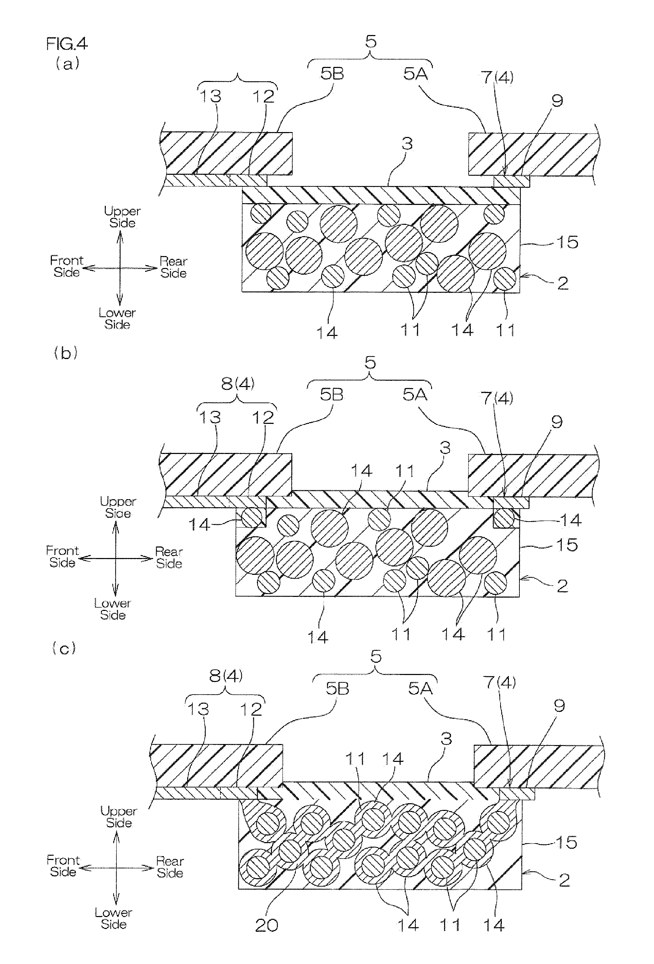

FIG. 1 shows a cross-sectional view of a conductive adhesive sheet in an embodiment of the present invention; FIG. 2 shows a solar cell module in an embodiment of the present invention; FIG. 3 shows a cross-sectional view taken along line A-A of the solar cell module shown in FIG. 2 (b); and FIG. 4 is a process drawing illustrating a method for producing a solar cell module shown in FIG. 3.

The directions of the conductive adhesive sheet 1 and the solar cell module 6 are based on the arrows showing directions in FIG. 1 to FIG. 4.

In FIG. 3, lead-free solder particles 14, high melting point metal particles 11, and a resin 15 are omitted to clearly show relative positions of the light reflective layer 3 and the conductive adhesive layer 2.

In FIG. 1, as shown in FIG. 2 (b), the conductive adhesive sheet 1 is formed into an elongated sheet extending in the front-back directions, and includes a conductive adhesive layer 2, and a light reflective layer 3 formed on the surface (one surface in the thickness direction) of the conductive adhesive layer 2.

The conductive adhesive layer 2 is formed from a conductive adhesive composition.

The conductive adhesive composition contains, for example, lead-free solder particles, high melting point metal particles, and a resin.

The lead-free solder that forms the lead-free solder particles is a solder that does not contain lead, and examples thereof include low melting point metal alloys such as a tin-bismuth alloy (Sn-Bi) and a tin-silver-copper alloy (Sn-Ag-Cu). Preferably, a tin-bismuth alloy is used.

The amount of tin in the tin-bismuth alloy is, for example, 10 to 50 mass%, preferably 25 to 45 mass%, and the amount of bismuth is, for example, 50 to 90 mass%, preferably 55 to 75 mass%.

The lead-free solder has a melting point of, for example, 200°C or less, and for example, 140°C or more.

The form of the lead-free solder particles is not particularly limited, and for example, the lead-free solder particles is spherical, plate-like, or needle-like. Preferably, spherical lead-free solder particles are used.

The lead-free solder particles have an average maximum length of (when spherical, the average particle size), for example, 10 to 50 µm, preferably 20 to 40 µm. When the lead-free solder particles have an average maximum length below the above-described range, the lead-free solder particles are easily oxidized, and melting (described later, ref: FIG. 4 (c)) of the lead-free solder particles at a desired temperature (to be specific, 200°C or less) may become difficult. On the other hand, when the lead-free solder particles have an average maximum length of more than the above-described range, forming of the conductive adhesive sheet 1 into a thin sheet may become difficult.

The average maximum length is measured by using a laser diffraction/scattering particle size distribution analyzer. The average maximum lengths of the high melting point metal particles and the reflective particles to be described later are also measured by such a method.

The lead-free solder particles can be used singly or in a combination of two or more.

Examples of the high melting point metal that forms the high melting point metal particles include silver, copper, gold, platinum, titanium, zinc, aluminum, iron, nickel, and alloys thereof. Preferably, copper is used.

The high melting point metal has a melting point of, for example, 300°C or more, preferably 400°C or more.

The high melting point metal particles have an average maximum length (when spherical, average particle size) of, for example, 10 to 50 µm, preferably 20 to 40 µm. When the high melting point metal particles have an average maximum length below the above-described range, densely filling with the high melting point metal particles may become difficult. On the other hand, when the high melting point metal particles have an average maximum length of more than the above-described range, forming of the conductive adhesive sheet 1 into a thin sheet may become difficult.

The high melting point metal particles can be used singly or in a combination of two or more.

Examples of the resin include a thermosetting resin.

Examples of the thermosetting resin include epoxy resin, thermosetting polyimide, phenol resin, urea resin, melamine resin, diallyl phthalate resin, silicone resin, and thermosetting urethane resin.

For the thermosetting resin, preferably, epoxy resin, phenol resin, or thermosetting polyurethane resin is used, and more preferably, epoxy resin, or phenol resin is used.

Examples of the epoxy resin include aromatic epoxy resins such as bisphenol epoxy resin (e.g., bisphenol A epoxy resin, bisphenol F epoxy resin, bisphenol S epoxy resin, hydrogenated bisphenol A epoxy resin, dimer-acid-modified bisphenol epoxy resin, etc.), novolak epoxy resin (eg., phenol novolak epoxy resin, cresol novolak epoxy resin, biphenyl epoxy resin, etc.), naphthalene epoxy resin, fluorene epoxy resin (e.g., bisarylfluorene epoxy resin, etc.), and triphenylmethane epoxy resin (e.g., trishydroxyphenylmethane epoxy resin, etc.); nitrogen-containing-cyclic epoxy resins such as triepoxypropylisocyanurate (triglycidylisocyanurate), and hydantoin epoxy resin; aliphatic epoxy resin; alicyclic epoxy resin (e.g., dicyclo ring-type epoxy resin, etc.); glycidylether epoxy resin; and glycidylamine epoxy resin.

For the epoxy resin, preferably aromatic epoxy resin, more preferably bisphenol epoxy resin, and particularly preferably bisphenol F epoxy resin is used.

For the epoxy resin, a commercially available product may be used, to be specific, YSLV-80XY (bisphenol F epoxy resin, manufactured by Nippon Steel Chemical Co., Ltd.) is used.

Examples of the phenol resin include novolak phenol resin obtained by allowing phenol and formaldehyde to condensate in the presence of an acidic catalyst; and phenol-aralkyl resin synthesized from phenol and dimethoxyparaxylene or bis(methoxymethyl) biphenyl.

Preferably, phenol-aralkyl resin is used.

For the phenol-aralkyl resin, a commercially available product can be used. To be specific, MEH-7851-SS and MEHC-7800H (both manufactured by MEIWA PLASTIC INDUSTRIES, LTD.) are used.

The thermosetting resin can also be prepared as a resin composition containing a thermosetting resin and a curing agent by using a curing agent in combination.

Examples of the curing agent include organic phosphine compounds, imidazole compounds, amine compounds, acid anhydride compounds, amide compounds, hydrazide compounds, imidazoline compounds, and urea compounds. Preferably, organic phosphine compounds are used.

Examples of the organic phosphine compound include tetraphenylphosphoniumtetraphenylborate, tetraphenylphosphoniumtetra-p-toluylborate, and tetraphenylphosphoniumtriphenylborate.

For the curing agent, a commercially available general product can be used, to be specific, TPP-K (tetraphenylphosphoniumtetraphenylborate, manufactured by HOKKO CHEMICAL INDUSTRY CO., LTD.) is used.

The amount of the curing agent relative to 100 parts by mass of the thermosetting resin is, for example, 0.01 to 5 parts by mass, preferably 0.05 to 1 part by mass.

Examples of the resin also include thermoplastic resins.

Examples of the thermoplastic resin include polyolefin (e.g., polyethylene, polypropylene, ethylene-propylene copolymer, etc.), acrylic resin, polyester resin, polyvinyl acetate, an ethylene-vinyl acetate copolymer, polyvinyl chloride, polystyrene, polyacrylonitrile, polyamide (nylon (registered trademark)), polycarbonate, polyacetal, polyethylene terephthalate, polyphenylene oxide, polyphenylene sulfide, polysulfone, polyether sulfone, poly ether ether ketone, polyarylsulfone, thermoplasticpolyimide, thermoplastic urethane resin, polyaminobismaleimide, polyamideimide, polyetherimide, bismaleimidetriazine resin, polymethylpentene, fluorinated resin, liquid crystal polymer, an olefin-vinyl alcohol copolymer, ionomer, polyarylate, acrylonitrile-ethylene-styrene copolymer, an acrylonitrile-butadienestyrene copolymer, and an acrylonitrile-styrene copolymer.

For the thermoplastic resin, preferably, acrylic resin, and polyester resin are used, and more preferably, acrylic resin is used.

The acrylic resin is composed of an acrylic polymer, and examples of such an acrylic polymer include a polymer of a monomer containing alkyl (meth) acrylate having 1 to 12 carbon atoms in its alkyl moiety as a main component, including methyl (meth) acrylate, ethyl (meth) acrylate, propyl (meth) acrylate, butyl (meth) acrylate, hexyl (meth) acrylate, octyl (meth) acrylate, decyl (meth) acrylate, and dodecyl (meth) acrylate.

For the acrylic polymer, a commercially available product can be used. To be specific, LA polymer (manufactured by Kuraray Co., Ltd.), SG-700AS (manufactured by Nagase ChemteX Corporation), and UC-3510 (manufactured by TOAGOSEI CO., LTD.) are used.

These resins may be used singly or in a combination of two or more. Preferably, a thermosetting resin and a thermoplastic resin are used in combination, or a thermosetting resin is used alone.

As an example of a combination of a thermosetting resin and a thermoplastic resin, to be specific, a combination of epoxy resin and phenol resin as thermosetting resins, and acrylic resin as a thermoplastic resin may be used.

The amount of the thermosetting resin relative to the resin is, for example, 10 to 90 mass%, preferably 20 to 80 mass%. When epoxy resin and phenol resin are used in combination as thermosetting resins, the epoxy resin is used in an amount of, relative to the thermosetting resin, for example, 10 to 90 mass%, preferably 20 to 80 mass%; and phenol resin is used in an amount of, relative to the thermosetting resin, for example, 10 to 90 mass%, preferably 20 to 80 mass%.

The amount of the thermoplastic resin used in combination with the thermosetting resin relative to 100 parts by mass of the thermosetting resin is, for example, 10 to 90 parts by mass, preferably 20 to 80 parts by mass.

Furthermore, by using the resin with an activator, the resin can also be prepared as a resin composition containing a resin and an activator.

The activator is optionally blended to the resin composition to melt the lead-free solder particles easily.

Examples of the activator include organic carboxylic acids such as adipic acid, sebacic acid, 2-phenoxybenzoic acid.

The amount of the activator relative to the total amount of the lead-free solder particles and the high melting point metal particles is, for example, 0.1 to 20 mass%, preferably 0.5 to 5 mass%.

The proportion of the total amount in volume of the lead-free solder particles and the high melting point metal particles relative to the conductive adhesive composition is, for example, 50 to 90 vol%, preferably 60 to 85 vol%. When the proportion of the above-described the total volume amount is more than the above-described range, the lead-free solder particles and the high melting point metal particles may not be blended into the conductive adhesive composition. On the other hand, when the above-described total volume amount is below the above-described range, electrical connection may not be obtained.

The ratio of the lead-free solder particles relative to the high melting point metal particles (lead-free solder particles/high melting point metal particles) is, on the basis of volume, for example, 0.25 to 4, preferably 0.4 to 2.5. When the ratio is more than the above-described range, costs may increase. On the other hand, when the ratio is below the above-described lower limit, conductive path (described later, ref: FIG. 4 (c)) between the high melting point metal particles may not be obtained.

The conductive adhesive composition is prepared by blending the lead-free solder particles, the high melting point metal particles, the resin, and as necessary, an activator in the above-described amounts. To be specific, the above-described components are kneaded by a kneader, so as to prepare the conductive adhesive composition as a kneaded material.

Thereafter, the prepared kneaded material is molded into a sheet, thereby producing a conductive adhesive layer 2.

The conductive adhesive layer 2 is molded into a sheet, for example, by extrusion molding using a T-die.

The conductive adhesive layer 2 has a thickness of, for example, 10 to 200 µm, preferably 50 to 100 µm. When the thickness of the conductive adhesive layer 2 is more than the above-described range, costs may increase. On the other hand, when the thickness of the conductive adhesive layer 2 is below the above-described range, the thickness may become smaller than the average maximum length of the lead-free solder particles and/or the high melting point metal particles, and in such a case, molding into a sheet may be difficult.

The light reflective layer 3 is laminated on the entire top surface of the conductive adhesive layer 2.

The light reflective layer 3 is formed from a reflective composition.

The reflective composition contains reflective particles and a resin.

The reflective particles are blended in the reflective composition to impart light reflectivity to the light reflective layer 3. The reflective particles are, for example, white particles, and examples of such white particles include, to be specific, white pigment.

Examples of the white pigment include white inorganic pigment, and such white inorganic pigment include, for example, oxides such as titanium oxide particles, silicon oxide (silica) particles, aluminum oxide (alumina), zinc oxide, and zirconium oxide; and carbonates such as white lead (lead carbonate), and calcium carbonate; and clay minerals such as kaolin (kaolinite).

For the white inorganic pigment, preferably, oxide particles, more preferably, titanium oxide particles are used.

With titanium oxide particles, characteristics such as high whiteness, high light reflectivity, high dispersiveness, excellent weatherability, and high chemical stability can be obtained.

Such titanium oxide particles are, to be specific, particles composed of TiO₂ (titanium oxide (IV), titanium dioxide).

The form of the reflective particles is not particularly limited, and for example, spherical, plate-like, or needle-like. The reflective particles have an average maximum length of (when spherical, the average particle size), for example, 100 to 500 nm. When the average maximum length of the reflective particles is outside the above-described range, reflectance of the light reflective layer 3 for visible light (wavelength 300 to 800 nm) is reduced, and effects of sunlight reflection (described later) may not be obtained sufficiently.

For the resin, for example, the above-described resin may be used, and preferably, a combination of a thermosetting resin and a thermoplastic resin may be used.

For the thermosetting resin, preferably, an aromatic epoxy resin is used, and more preferably, bisphenol epoxy resin, or novolak epoxy resin is used, and particularly preferably, bisphenol A epoxy resin, or cresol novolak epoxy resin is used.

An example of a commercially available product of bisphenol A epoxy resin includes Epikote YL980 (manufactured by JER), and an example of a commercially available product of cresol novolak epoxy resin include KI-3000 (manufactured by JER).

For the thermoplastic resin, preferably, acrylic resin is used.

Examples of a commercially available product of acrylic resin include SG-700AS (manufactured by Nagase ChemteX Corporation) and UC-3510 (manufactured by TOAGOSEI CO., LTD.).

The amount of the thermosetting resin relative to the resin is, for example, 10 to 90 mass%, preferably 20 to 80 mass%. When epoxy resin and phenol resin are used in combination as the thermosetting resin, the amount of the epoxy resin relative to the thermosetting resin is, for example, 10 to 90 mass%, preferably 20 to 80 mass%.

The amount of the thermoplastic resin relative to 100 parts by mass of the thermosetting resin is, for example, 10 to 90 parts by mass, preferably 20 to 80 parts by mass.

The amount of the reflective particles relative to the reflective composition is, on volume basis, for example, 10 to 40 vol%, preferably 15 to 35 vol%.

When the amount of the reflective particles is below the above-described range, the reflectance of the light reflective layer 3 decreases. Furthermore, to prevent such a decrease in reflectance, the thickness of the light reflective layer 3 has to be made larger to that extent. Then, as shown in FIG. 4 (c), fusion bonding (described later) of the lead-free solder particles 14 encapsulated by the light reflective layer 3 to the back electrode 4 may become difficult.

On the other hand, when the amount of the reflective particles is more than the above-described range, that is, when the amount of the resin is extremely small, the viscosity of the reflective composition becomes excessively high, and therefore fusion bonding (described later) of the lead-free solder particles 14 encapsulated by the light reflective layer 3 to the back electrode 4 may become difficult.

The amount of the resin relative to the reflective composition is, on volume basis, for example, 60 to 90 vol%, preferably 65 to 85 vol%.

The reflective composition can be prepared as a kneaded material, by blending reflective particles and a resin, and for example, by kneading the mixture with a kneader.

The light reflective layer 3 is formed by molding the prepared kneaded material into a sheet.

The light reflective layer 3 is molded into a sheet by extrusion molding with a T-die provided in a kneader.

The reflectance of the light reflective layer 3 for light at a wavelength of 460 nm is, for example, 70 to 90%.

The light reflective layer 3 has a thickness of, for example, 1 to 15 µm, preferably 5 to 12 µm. When the thickness of the light reflective layer 3 is more than the above-described range, as shown in FIG. 4 (c), fusion bonding (described later) of the lead-free solder particles 14 encapsulated by the light reflective layer 3 to the back electrode 4 may become difficult.

On the other hand, when the thickness of the light reflective layer 3 is below the above-described range, the reflectance of the light reflective layer 3 decreases, and effects of sunlight reflection (described later) may not be obtained sufficiently.

The conductive adhesive sheet 1 is obtained by, as shown in FIG. 1, bonding the above-described conductive adhesive layer 2 and the light reflective layer 3 together.

Next, with reference to FIG. 2 and FIG. 3, description is given below of a solar cell module 6 including a plurality of back contact solar cells 5 having back electrodes 4 connected by a conductive adhesive sheet 1 .

The solar cell module 6 includes, as shown in FIG. 2 (b), a plurality of back contact solar cells 5 disposed in the front-back directions in spaced-apart relation to each other, and a conductive adhesive sheet 1 that connects the back electrodes 4 of the plurality of back contact solar cells 5.

As shown in FIG. 2 (a), the back contact solar cell 5 is formed into a generally rectangular shape when viewed from the top, and the plurality of back contact solar cells 5 are arranged in line along the front-back directions. The top surfaces of the plurality of back contact solar cells 5 serve as a light-receiving surface that receives sunlight and generates electric energy. Meanwhile, as shown in FIG. 2 (b), back electrodes 4 for taking out the electric energy generated at the light-receiving surface are provided at the bottom surfaces (rear surface) of the plurality of back contact solar cells 5.

The back electrodes 4 are formed into an electrode pattern having a positive electrode 7 and a negative electrode 8.

The positive electrode 7 is formed into a generally comb shape with opening toward a rear side. To be specific, the positive electrode 7 integrally includes, at the front end portion of the rear surface of the back contact solar cell 5, a positive electrode-side current collecting portion 9 extending in the left-right directions, and a plurality of positive electrode-side comb tooth portions 10 extending toward the rear side from the positive electrode-side current collecting portion 9 and arranged parallely in the left-right directions in spaced-apart relation to each other.

The negative electrode 8 is formed into a generally comb shape with opening toward the front side. To be specific, the negative electrode 8 integrally includes, at the rear end portion of the rear surface of the back contact solar cell 5, a negative electrode-side current collecting portion 12 extending in the left-right directions, and a plurality of negative electrode-side comb tooth portions 13 extending from the negative electrode-side current collecting portion 12 toward the front side and arranged parallely in the left-right directions in spaced-apart relation to each other.

In the back electrode 4, the positive electrode-side comb tooth portion 10 and the negative electrode-side comb tooth portion 13 are alternately disposed in spaced-apart relation in the left-right directions.

The conductive adhesive sheet 1 connects, as shown in FIG. 2 (b) and FIG. 3, the back electrodes 4 of the back contact solar cells 5 that are adjacent to each other in front-back directions. For example, the conductive adhesive sheet 1 allows connection between the positive electrode 7 of the first back contact solar cell 5A and the negative electrode 8 of the second back contact solar cell 5B that is disposed adjacently in front of the first back contact solar cell 5A.

To be specific, the conductive adhesive sheet 1 allows connection between the positive electrode 7 and the negative electrode 8 so as to extend over the positive electrode-side current collecting portion 9 of the first back contact solar cell 5A and the negative electrode-side current collecting portion 12 of the second back contact solar cell 5B. To be more specific, the top surface of the both end portions in the front-back directions of the light reflective layer 3 are in contact with the edge portion (inner side portion) of the positive electrode-side current collecting portion 9 of the first back contact solar cell 5A, and with edge portion (inner side portion) of the negative electrode-side current collecting portion 12 of the second back contact solar cell 5B.

As shown in FIG. 3, at both end portions in the front-back directions of the conductive adhesive sheet 1, the light reflective layer 3 is not formed at a portion facing the back electrode 4, and the surface of the conductive adhesive layer 2 not overlapping the light reflective layer 3 is directly in contact with the back electrode 4.

Thus, as shown in FIG. 3, in the conductive adhesive sheet 1, the conductive adhesive layer 2 at both end portions in the front-back directions is allowed to directly contact with the positive electrode-side current collecting portion 9 of the first back contact solar cell 5A and the negative electrode-side current collecting portion 12 of the second back contact solar cell 58.

On the other hand, the light reflective layer 3 at the middle portion of the conductive adhesive sheet 1 in the front-back directions is exposed from the gaps between the plurality of back contact solar cells 5 to the upper side, and is allowed to directly contact with the bottom surface and the side surface of the end portions of the first back contact solar cell 5A and the second back contact solar cell 5B at the side where they are facing each other (inner side).

Next, description is given below of a method for producing a solar cell module 6 with reference to FIG. 2 to FIG. 4.

In this method, as shown in FIG. 2 (a) and FIG. 2 (b), a plurality of back contact solar cells 5 are prepared, and these are arranged in line in the front-back directions.

Thereafter, as shown in FIG. 4 (a), the conductive adhesive sheet 1 is placed on the rear surface of the back contact solar cell 5 so as to extend over the positive electrode-side current collecting portion 9 and the negative electrode-side current collecting portion 12 of the adjacent back contact solar cells 5.

Then, as shown in FIG. 4 (b) and FIG. 4 (c), the conductive adhesive sheet 1 is allowed to adhere to the back electrodes 4 (the positive electrode 7 and the negative electrode 8).

To allow the conductive adhesive sheet 1 to adhere to the back electrodes 4, as shown in FIG. 4 (b), the conductive adhesive sheet I and the back electrodes 4 are thermocompression bonded (first thermocompression bonding step).

The temperature in the first thermocompression bonding step is, for example, 80°C or more and below 140°C, preferably 100°C or more and 130°C or less, and the pressure is, for example, 0.1 to 2MPa, preferably 0.2 to 1MPa.

In the first thermo compression bonding step, as shown in FIG. 4 (b), the conductive adhesive sheet 1 softens.

To be specific, when the conductive adhesive composition contains a thermosetting resin, the thermosetting resin is brought into B-stage state (semi-cured state). Furthermore, when the conductive adhesive layer 2 contains a thermoplastic resin, the thermosetting resin softens.

Furthermore, when the reflective composition contains a thermosetting resin, the thermosetting resin is brought into B-stage state (semi-cured state). Furthermore, when the conductive adhesive layer 2 contains a thermoplastic resin, the thermosetting resin softens.

Therefore, in the back contact solar cell 5, the light reflective layer 3 facing the back electrodes 4 moves downwardly, and enters into the B-staged and/or softened conductive adhesive layer 2. In other words, the light reflective layer 3 (widthwise center) that does not face the back electrode 4 in the thickness direction relatively moves upwardly relative to the light reflective layer 3 (widthwise both end portions) that faces the back electrode 4.

As shown in FIG. 4 (b), the widthwise both end portions of the light reflective layer 3 that entered into the conductive adhesive layer 2 encapsulate (embeds) the lead-free solder particles 14. The lead-free solder particles 14 that are encapsulated in the light reflective layer 3 are in contact with the back electrode 4, or present in the proximity of the back electrode 4.

Thereafter, as shown in FIG. 4 (c), the conductive adhesive sheet 1 and the back electrodes 4 are further thermocompression bonded (second thermocompression bonding step).

In the second thermocompression bonding step, the temperature is, for example, 140°C or more, and 200°C or less, and the pressure is, for example, 0.1 to 2MPa, preferably 0.2 to 1MPa.

In the second thermocompression bonding step, as shown in FIG. 4 (c), the lead-free solder particles 14 are melted, to fusion connect the high melting point metal particles 11.

To be specific, the lead-free solder particles 14 cover the high melting point metal particles 11 that are adjacent to each other, and are formed to be continuous, extending over the high melting point metal particles 11. Thus, a conductive path 20 composed of a lead-free solder that forms the lead-free solder particles 14 is formed in the conductive adhesive layer 2.

Furthermore, the lead-free solder particles 14 that are facing the back electrode 4 fusion bond (weld) the bottom surface of the back electrodes 4. In this manner, the conductive path 20 that electrically connects (allows electrical continuity) the positive electrode 7 and the negative electrode 8 is formed.

At the same time, when the conductive adhesive composition and/or the reflective composition contain a thermosetting resin, the thermosetting resin is brought into C stage state (completely cured).

On the other hand, in the light reflective layer 3, in the portion that is thermocompression bonded to the back contact solar cell 5, when the reflective composition contains a thermoplastic resin, the thermosetting resin melts, and therefore the reflective particles are diffused in the conductive adhesive layer 2. Thus, as shown in FIG. 4 (c), the light reflective layer 3 that faces the back contact solar cell 5 substantially disappears.

By the second thermocompression bonding step, the conductive adhesive sheet 1 is allowed to adhere to the back electrodes 4 (the positive electrode 7 and the negative electrode 8) of the back contact solar cell 5.

In the solar cell module 6, the conductive adhesive sheet 1 connects the back electrodes 4 of the plurality of back contact solar cells 5 disposed in spaced-apart relation to each other. Thus, while the plurality of back contact solar cells 5 are bonded and fixed, electrical conduction between the back electrodes 4 is achieved.

On the other hand, in the light reflective layer 3 that is exposed to the front side from between the back contact solar cells 5, sunlight that passes through the gaps between the back contact solar cells 5 can be reflected, and therefore the reflected light can be received in the back contact solar cells 5. Thus, the sunlight that passes through the gaps between the back contact solar cells 5 can be effectively used.

The conductive adhesive layer 2 and the light reflective layer 3 allow reinforcement around the solder joining portion between the conductive adhesive sheet 1, and the back electrodes 4 joined by the conductive adhesive sheet 1. In particular, when the conductive adhesive layer 2 and the light reflective layer 3 contain resin, the resin reinforces the above-described portion for sure.

Thus, reliability of the solar cell module 6 including the back contact solar cells 5 including the back electrodes 4 connected by the conductive adhesive sheet 1 can be improved.

In the embodiment shown in the solid line of FIG. 3, the rear surface of the conductive adhesive layer 2 is exposed. However, for example, as shown by the phantom line in FIG. 3, a metal foil 16 can be provided on the rear surface of the conductive adhesive layer 2.

The metal foil 16 is laminated on the entire rear surface of the conductive adhesive layer 2.

Examples of metals that form the metal foil 16 include copper, silver, and gold. Preferably, copper is used.

The metal foil 16 has a thickness of, for example, 18 to 150 µm, preferably 30 to 75 µm.

In the embodiment shown in the phantom line of FIG. 3, in addition to the operational advantage shown in the solid line of FIG. 3, the metal foil 16 supports the conductive adhesive layer 2 to further improve the mechanical strength of the solar cell module 6.

### Example

Hereinafter, the present invention is described in further detail with reference to Examples and Comparative Examples. However, the present invention is not limited to those described in Examples and Comparative Examples.

### Example 1

### (Production of Conductive Adhesive Layer)

A resin composition was prepared as a kneaded material by blending 32 parts by mass of epoxy resin (YSLV-80XY, bisphenol F epoxy resin, manufactured by Nippon Steel Chemical Co., Ltd.); 33 parts by mass of phenol resin (MEH-7851-SS, phenol-aralkyl resin, manufactured by MEIWA PLASTIC INDUSTRIES, LTD.); 30 parts by mass of acrylic resin (LA polymer, acrylic polymer, manufactured by Kuraray Co., Ltd.); and 5 parts by mass of active agent (2-phenoxybenzoic acid).

Thereafter, the resin composition, lead-free solder particles (42Sn-58Bi, copper-bismuth alloy particles, melting point 139°C, spherical, average particle size 35 µm), and copper particles (melting point 1083°C, spherical, average particle size 20 µm) were kneaded so that their volume ratio was 30: 20: 50, thereby preparing a conductive adhesive composition as a kneaded material.

Thereafter, the kneaded material was molded into a 50 µm sheet, thereby producing a conductive adhesive layer.

### (Production of Light Reflective Layer)

A varnish was prepared by blending the following in 41 parts by mass of methyl ethyl ketone: 41 parts by mass of acrylic resin A (SG-700AS, acrylic polymer, manufactured by Nagase ChemteX Corporation); 1.7 parts by mass of acrylic resin B (UC-3510, acrylic polymer, manufactured by TOAGOSEI CO., LTD.); 7.9 parts by mass of epoxy resin A (KI-3000, cresol novolak epoxy resin, manufactured by JER); 21 parts by mass of epoxy resin B (EpikoteYL980, bisphenol A epoxy resin, manufactured by JER); 28 parts by mass of phenol resin (MEHC-7800H, phenol-aralkyl resin, manufactured by MEIWA PLASTIC INDUSTRIES.LTD.); and 0.068 parts by mass of a curing agent (TPP-K, tetraphenylphosphoniumtetraphenylborate, manufactured by HOKKO CHEMICAL INDUSTRY CO., LTD.).

Thereafter, the varnish and titanium oxide particles (spherical, average particle size 250 nm) were mixed so that their volume ratio was 82: 18 (solid content: titanium oxide particles), and the mixture was kneaded so that their volume ratio was 30: 20: 50, thereby preparing a reflective composition as a kneaded material.

Thereafter, the kneaded material was molded into a 10 µm sheet, thereby producing a light reflective layer.

### (Production of Conductive Adhesive Layer)

The conductive adhesive layer and the light reflective layer were bonded together, thereby producing a conductive adhesive sheet (ref: FIG. 1).

### Example 2

A conductive adhesive layer was made in the same manner as in Example 1, except that the resin composition, the lead-free solder particles, and the copper particles were kneaded so that the volume ratio between them was 30: 35: 35 in the preparation of a conductive adhesive layer; and then a conductive adhesive sheet was made.

### Example 3

A conductive adhesive layer was made in the same manner as in Example I , except that the resin composition, the lead-free solder particles, and the copper particles were kneaded so that the volume ratio between them was 30: 50: 20 in the preparation of a conductive adhesive layer; and then a conductive adhesive sheet was made.

### Example 4

A conductive adhesive layer was made in the same manner as in Example 1, except that in the preparation of the conductive adhesive layer, lead-free solder particles (Sn-Ag-Cu, 96.5: 3: 0.5 mass ratio, melting point 220°C, spherical, average particle size 35 µm) were blended instead of the lead-free solder particles (42Sn-58Bi); and then a conductive adhesive sheet was made.

### Example 5

A conductive adhesive layer was made in the same manner as in Example 1, except that the resin composition, the lead-free solder particles, and the copper particles were kneaded so that the volume ratio between them was 30: 10: 60 in the preparation of a conductive adhesive layer; and then a conductive adhesive sheet was made.

### Comparative Example 1

A resin layer composed of acrylic resins A and B, a phenol resin, epoxy resins A and B, and a curing agent was made in the same manner as in Example 1, except that titanium oxide particles were not blended in the production of the light reflective layer; and then a conductive adhesive sheet was made.

The mixing formulations in Examples 1 to 5 and Comparative Example 1 are shown in Table 1.

The values in Table 1 are based on parts by volume unless specified otherwise.

**Table 1**

| | Conductive Adhesive Layer | | | | Light Reflective Layer*¹ | | Evaluation | |
|---|---|---|---|---|---|---|---|---|
| | Lead-Free Solder Particles | | High Melting Point Metal Particles | Resin Composition | TiO₂ particles | Resin Composition | Adhesiveness | Light Reflectivity |
| | Sn-Ag-Cu | Sn-Bi | | | | | | |
| Example 1 | - | 20 | 50 | 30 | 18 | 82 | Good | Good |
| Example 2 | - | 35 | 35 | 30 | 18 | 82 | Good | Good |
| Example 3 | - | 50 | 20 | 30 | 18 | 82 | Good | Good |
| Example 4 | 20 | - | 50 | 30 | 18 | 82 | Poor | Good |
| Example 5 | - | 10 | 60 | 30 | 18 | 82 | Poor | Good |
| Comparative Example 1 | - | 20 | 50 | 30 | - | 100 | Good | Bad |

| | | | | | | | | |
|---|---|---|---|---|---|---|---|---|
| * 1 :Resin Layer in Comparative Example 1 | | | | | | | | |

### Evaluation

### 1. Adhesiveness

Adhesiveness of the conductive adhesive sheets was evaluated by allowing the conductive adhesive sheet of Examples and Comparative Examples to adhere to copper foil with its front surface and rear surface covered (plated) with tin, and conducting their continuity test.

That is, first, copper foil was placed on the surface of light reflective layer of the conductive adhesive sheet (ref: FIG. 4 (a)).

Then, the conductive adhesive sheet and copper foil were thermocompression bond under the following conditions: 0.5MPa, 170°C, and for 1 min (first thermocompression bonding step, ref: FIG. 4 (b)).

The conductive adhesive sheet was softened in this manner.

Subsequently, the conductive adhesive sheet and copper foil were thermocompression bond under the following conditions: 0.5MPa, 110°C, and for 1 min (second thermocompression bonding step, ref: FIG. 4 (c)).

The conductive adhesive sheet was allowed to adhere to the copper foil in this manner.

The surfaces of the copper particles were covered with the lead-free solder particles, and the light reflective layer disappeared. A conductive path electrically connecting with the copper foil was formed in the conductive adhesive layer.

Then, adhesive state between the conductive adhesive sheet and the copper foil was evaluated based on the following evaluation criteria.

Good: Sufficient adhesion between the conductive adhesive sheet and the copper foil.

Poor: the conductive adhesive sheet and the copper foil were allowed to adhere to each other, but the adhesion was slightly insufficient.

Bad: No adhesion between the conductive adhesive sheet and the copper foil.

### 2. Light Reflectivity

The reflectance of the conductive adhesive sheets of Examples and Comparative Examples for light at a wavelength of 460 nm was measured with a spectrometer for evaluation.

Then, the light reflectivity of the conductive adhesive sheet was evaluated based on the following evaluation criteria.

Good: the reflectance of the conductive adhesive sheet was 70% or more.

Bad: the reflectance of the conductive adhesive sheet was below 70%.

While the illustrative embodiments of the present invention are provided in the above description, such is for illustrative purpose only and it is not to be construed as limiting the scope of the present invention. Modifications and variations of the present invention that will be obvious to those skilled in the art is to be covered by the appended claims.

## Claims

1. A conductive adhesive sheet comprising:
a conductive adhesive layer, and
a light reflective layer formed on one surface in the thickness direction of the conductive adhesive layer.

2. The conductive adhesive sheet according to Claim 1,
wherein the conductive adhesive layer is formed from
a conductive adhesive composition comprising lead-free solder particles, high melting point metal particles, and a resin.

3. The conductive adhesive sheet according to Claim 2, wherein the lead-free solder particles have a melting point of 200°C or less.

4. The conductive adhesive sheet according to Claim 2, wherein the lead-free solder particles are a tin-bismuth alloy.

5. The conductive adhesive sheet according to Claim 2, wherein the amount of the lead-free solder particles relative to the conductive adhesive composition is 15 vol% or more and 90 vol% or less.

6. The conductive adhesive sheet according to Claim 2, wherein the resin contains a thermosetting resin.

7. The conductive adhesive sheet according to Claim 2, wherein the conductive adhesive composition further contains an activator.

8. The conductive adhesive sheet according to Claim 1, wherein the light reflective layer contains titanium oxide particles.

9. A solar cell module comprising:
a plurality of back contact solar cells disposed in spaced-apart relation to each other,
a conductive adhesive sheet that connects the back electrodes of the plurality of back contact solar cells so that a light reflective layer is exposed to a front side from gaps between the plurality of back contact solar cells,
wherein the conductive adhesive sheet comprises
a conductive adhesive layer, and
the light reflective layer formed on one surface in the thickness direction of the conductive adhesive layer.
